**Europäisches Patentamt**

**European Patent Office**

**Office européen des brevets**

(19)

(11) Veröffentlichungsnummer : **0 373 329 B1**

(12)

# EUROPÄISCHE PATENTSCHRIFT

(45) Veröffentlichungstag der Patentschrift :
**27.12.95 Patentblatt 95/52**

(51) Int. Cl.$^6$ : **G03F 7/20, G03F 7/12**

(21) Anmeldenummer : **89119818.6**

(22) Anmeldetag : **25.10.89**

(54) **Verfahren zur lithographischen Herstellung von galvanisch abformbaren Mikrostrukturen mit dreieckigem oder trapezförmigem Querschnitt**

(30) Priorität : **16.12.88 DE 3842354**

(43) Veröffentlichungstag der Anmeldung :
**20.06.90 Patentblatt 90/25**

(45) Bekanntmachung des Hinweises auf die
Patenterteilung :
**27.12.95 Patentblatt 95/52**

(84) Benannte Vertragsstaaten :
**AT CH FR GB IT LI NL SE**

(56) Entgegenhaltungen :
**EP-A- 0 124 064**
**US-A- 4 444 616**

(73) Patentinhaber : **Forschungszentrum Karlsruhe GmbH**
**Weberstrasse 5**
**D-76133 Karlsruhe (DE)**

(72) Erfinder : **Maner, Asim, Dr.**
**Zwölfmorgen 8**
**D-7515 Linkenheim (DE)**
Erfinder : **Mohr, Jürgen, Dr.**
**Hasenstrasse 11**
**D-7519 Sulzfeld (DE)**

(74) Vertreter : **Gottlob, Peter, Dipl. Ing.**
**Forschungszentrum Karlsruhe GmbH**
**Stabsabteilung**
**Patente und Lizenzen**
**Weberstrasse 5**
**D-76133 Karlsruhe (DE)**

## Beschreibung

Die Erfindung betrifft ein Verfahren zur lithographischen Herstellung von galvanisch abformbaren Mikrostrukturen mit dreieckigem oder trapezförmigem Querschnitt aus Resistmaterial entsprechend dem Oberbegriff des Hauptanspruchs.

Ein solches Verfahren ist aus der Veröffentlichung von J. Mohr, W. Ehrfeld und D. Münchmeyer, Kernforschungszentrum Karlsruhe, Bericht KfK-4414, mit dem Titel "Analyse der Defektursachen und der Genauigkeit der Strukturübertragung bei Röntgentiefenlithographie mit Synchrotronstrahlung" unter der Bezeichnung "LIGA-Verfahren" bekannt.

In dieser Veröffentlichung wird die Herstellung von Mikrostrukturen mit schrägen, d. h. zur Ebene der Resistschicht geneigten Wänden erwähnt. In Kapitel 2 werden die Auswirkungen einer (relativ zur einfallenden Strahlung) schräg stehenden Maskenstruktur auf die Qualität der erzeugten Mikrostrukturen diskutiert.

Danach lassen sich durch Schrägstellung der Maskenebene geneigt auf der Resistebene stehende Strukturen und somit prinzipiell Mikrostrukturen mit dreieckigem oder trapezförmigem Querschnitt herstellen. Nach KfK-4414 führt jedoch diese Schrägstellung zu einer Dosisverschmierung im Kantenbereich. Im Bereich der Kanten der herzustellenden Mikrostrukturen werden Teile des Resistmaterials durch Reflexions- und Beugungseffekte partiell bestrahlt.

Bei der Entwicklung der Resiststrukturen werden die partiell bestrahlten Teile des Resistmaterials zum Teil abgelöst, weshalb bei der nachfolgenden Galvanisierung verzerrte und wenig exakte Mikrostrukturen erhalten werden.

Weiterhin wird der Einfluß von senkrecht zum einfallenden Strahl angeordneten Masken untersucht, deren Öffnungen relativ zum Strahl geneigte Wände aufweisen.

Entsprechend Seite 86 des zitierten Berichts sehen die Autoren hierin eine attraktive Möglichkeit, um gezielt konische Mikrostrukturen mit kleinem Konizitätswinkel herzustellen.

Bei diesem Vorschlag erweist es sich jedoch als nachteilig, daß zuvor Maskenstrukturen mit geneigten Wänden angefertigt werden müssen und daß die Konizität auf kleine Winkel beschränkt bleibt. Weiterhin muß für jede gewünschte Mikrostruktur eine eigene Maske mit definiert abgeschrägten Wänden angefertigt werden.

Aus der EP-A 0 124 064 ist ein Verfahren zur Erzeugung von rotations-unsymmetrischen, kegelförmigen Resiststrukturen bekannt, bei dem ein Träger mit einer aufgebrachten Resistschicht durch eine Maske bestrahlt wird. Der Träger kann zugleich als Maske dienen oder es wird eine getrennt hergestellte Maske auf die Resistschicht aufgelegt. Während der Bestrahlung wird die Resistschicht mitsamt dem Träger und ggf. der Maske nicht näher beschriebenen Dreh- und Wippbewegungen ausgesetzt. Danach wird die Resistschicht entwickelt. Während der Durchführung des Verfahrens bleibt die Maske bzw. der als Maske wirkende Träger nicht senkrecht zu der einfallenden Strahlung orientiert.

Aufgabe der Erfindung ist, die genannten Nachteile zu vermeiden. Es soll ein Verfahren angegeben werden, mit dem Mikrostrukturen mit dreieckigem oder trapezförmigem Querschnitt unter Verwendung der üblichen Masken mit senkrechten Wänden hergestellt werden können. Die Neigung der Mikrostrukturwände der erzeugten Strukturen soll innerhalb weiter Grenzen frei wählbar sein, ohne daß die Maskenstruktur verändert wird.

Die Linearität der Mikrostrukturwände darf durch Reflexions- und Beugungserscheinungen des Strahls bzw. der Strahlung und damit durch fließende Übergänge zwischen bestrahlten und unbestrahlten Resistbereichen nicht beeinträchtigt werden.

Die Aufgabe wird erfindungsgemäß durch die im Kennzeichen des Hauptanspruchs aufgeführten Maßnahmen gelöst.

Die Unteransprüche geben vorteilhafte Ausgestaltungen des erfindungsgemäßen Verfahrens an.

Erfindungsgemäß wird eine Maske verwendet, deren Durchbrüche oder Öffnungen senkrecht zur Maskenebene verlaufende Wände aufweisen. Die Maskenebene wird senkrecht zur einfallenden Strahlung justiert. Solche Masken lassen sich mit den bekannten Verfahren wesentlich einfacher herstellen als Masken mit Öffnungen oder Durchbrüchen, deren Wände einen definierten Winkel relativ zur Maskenebene aufweisen.

Für das erfindungsgemäße Verfahren werden vorzugsweise Masken mit schlitzförmigen Öffnungen verwendet.

Die Resistschicht mit ihrer elektrisch leitenden Unterlage wird für eine erste Bestrahlung um einen Winkel $(+\alpha)$ aus der zur Maskenebene parallelen und damit zum einfallenden Strahl senkrechten Ebene herausgedreht. Danach wird die Resistschicht bestrahlt.

Anschließend wird die Resistschicht um einen Winkel $(-\alpha)$ aus der zur Maskenebene parallelen Ebene herausgedreht und wiederum bestrahlt. Der Vorgang kann wiederholt werden, nachdem die zweimal bestrahlte Resistschicht innerhalb der zur Maskenebene parallelen Ebene um einen Winkel $\beta$ gedreht wurde. Die Entwicklung der Probe kann nach Abschluß aller Bestrahlungen erfolgen und braucht nicht nach jeder Bestrahlung vorgenommen werden.

Der Winkel $\alpha$ wird so gewählt, daß sich die bestrahlten Abschnitte nach der ersten und zweiten Bestranlung an der Grenzfläche von Resistmaterial und elektrisch leitender Unterlage überlappen.

Je nach gewähltem Winkel $\alpha$ werden in Abhängigkeit von der Schichtdicke d des Resistmaterials und des Schlitzabstands a der Maske Mikrostrukturen mit dreieckigem oder trapezförmigem Querschnitt erhalten.

Trapezförmige Querschnitte ergeben sich, wenn
$$\alpha < \arcsin (a/2d)$$
während mit
$$\alpha = \arcsin (a/2d)$$
dreieckige Querschnitte resultieren.

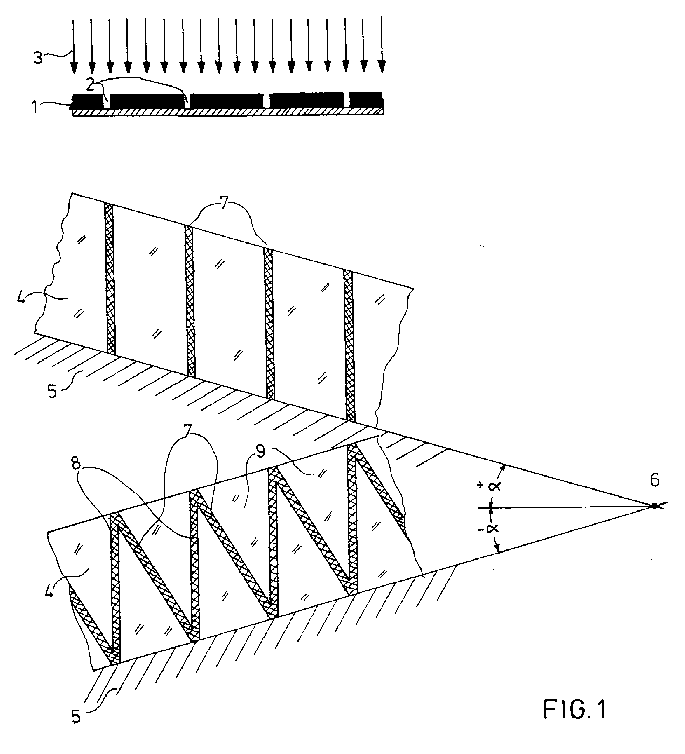

Die Anordnung von Maske und Resistschicht relativ zur einfallenden Strahlung sind in Fig. 1 dargestellt.

Die Maske 1 mit den Schlitzen 2 wird senkrecht zu den einfallenden Strahlen 3 ausgerichtet.

Die Schlitze 2 sind im Abstand a auf der Maske angebracht und weisen senkrechte Wände auf.

Für die erste Bestrahlung wird die Resistschicht 4, die auf einer elektrisch leitenden Unterlage 5 aufgebracht ist, um die Drehachse 6 aus einer zur Maskenebene parallelen Ebene um den Winkel (+ $\alpha$) gedreht. Die Drehachse 6 liegt in der Ebene der Grenzfläche zwischen Resistschicht 4 und der Unterlage 5.

Die nicht durch die Maske absorbierten Strahlen durchdringen bänderförmige Bereiche 7 innerhalb der Resistschicht 4. Der Winkel und der Abstand dieser bänderförmigen Bereiche wird durch den Schlitzabstand a der Maske und den Drehwinkel a der Resistschicht 4 bestimmt.

Für die Zweite Bestrahlung wird die Resistschicht um den Winkel (- $\alpha$) relativ zur Maskenebene um den Drehachse 6 gedreht.

Wiederum werden bänderförmige Bereiche 8 in der Resistschicht bestrahlt.

Die bänderförmigen Bereiche 7 und 8 überlappen sich an der Grenzfläche von Resistschicht und Unterlage und, bei Mikrostrukturen mit dreieckigem Querschnitt, an der Oberfläche der Resistschicht.

Maske und Resistschicht lassen sich in der in KfK-4414 beschriebenen Weise herstellen.

Als Resistsaterial kann Polymethylmethacrylat (PMMA) oder ein anderes für das LIGA-Verfahren geeignetes Material verwendet werden.

Die bestrahlten Bereiche werden in der bekannten Weise entwickelt.

Für das erfinducsgemäße Verfahren ist wesentlich, daß bei der Entwicklung nicht nur die bestrahlten Bereiche entfernt werden, sondern auch die unbestrahlten Bereiche 9 herausfallen, die eine bänderförmige Struktur mit dreieckigem Querschnitt aufweisen, da die sie umgebenden Teile des Resistmaterials herausgelöst werden.

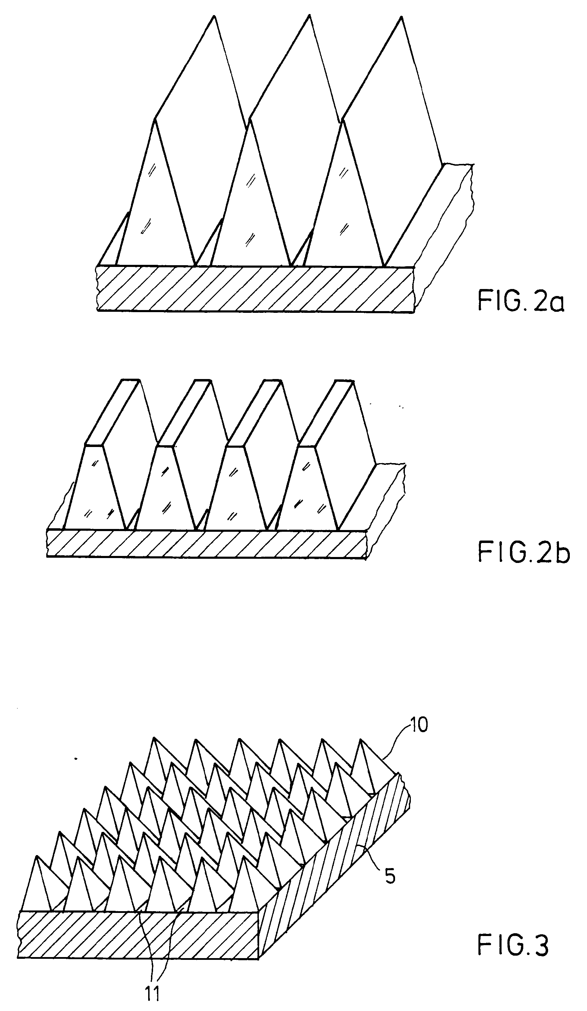

Fig. 2 zeigt die zweifach bestrahlte und entwickelte Resistschicht.

Teil a stellt Resistblöcke mit dreieckigen, Teil b Resistblöcke mit trapezförmigen Querschnitten der Mikrostrukturen dar.

Diese Resistblöcke lassen sich in der üblichen Weise galvanisch abformen.

Die entwickelten Resistblöcke können jedoch auch einer weiteren zweifachen Bestrahlung unterworfen werden, indem sie innerhalb einer zur Maskenebene parallelen Ebene um einen bestimmten Winkel $\beta$, etwa 90°, gedreht werden, wonach das beschriebene Verfahren wiederholt wird.

Für den Fall, daß der Winkel $\beta$ 90° beträgt und der Winkel $\alpha$ gleich arcsin (a/2d) ist, erhält man den in Fig. 3 gezeigten Resistblock.

Dieser Resistblock weist auf der Unterlage 5 eine Vielzahl von quadratischen Pyramiden 10 auf, die durch ein Netz rechtwinklig verlaufender Nuten 11 voneinander getrennt sind.

In den Nuten 11 wird die elektrisch leitende Unterlage freigelegt.

Die Erfindung wird im folgenden anhand von Durchführungsbeispielen näher erläutert.

Beispiel

Eine Maske der Größe 4 x 4 cm², die Schlitze von 3 cm Länge und 20 $\mu$m Breite in jeweils 220 $\mu$m Abstand aufweist, wird senkrecht zu den einfallenden Strahlen einer Röntgen-Strahlenquelle justiert.

Eine Resistschicht von 2 x 2 cm² mit einer Dicke von 400 $\mu$m aus PMMA wird auf einer Metallplatte aufgebracht, wobei die Metallplatte als Unterlage dient.

Die Resistschicht wird im Abstand von 3 mm von der Maskenebene justiert und während der ersten Bestrahlung um einen Winkel von (+ $\alpha$) = 16° aus der Ebene gedreht.

Nach der ersten Bestrahlung wird die Resistschicht um den Winkel (- $\alpha$) aus der Ebene gedreht und wiederum bestrahlt.

Anschließend wird die Resistschicht in der üblichen Weise entwickelt, wodurch sich eine zur Fig. 2a analoge Struktur ergibt.

Die auf diese Weise vorbehandelte Resistschicht wird parallel zur Maskenebene um den Winkel $\beta$ = 90° gedreht und wiederum in der angegebenen Weise zweimal bestrahlt.

Nach der Entwicklung liegen quadratisch-pyramidale Mikrostrukturen analog zu Fig. 3 vor.

Diese Mikrostrukturen werden in der bekannten Weise galvanisch abgeformt. Nach der Entfernung der Resiststrukturen und der Unterlage erhält man ein Werkzeug mit pyramidalen Öffnungen, mit dem durch Abformung pyramidenförmige Kunststoffstrukturen hergestellt werden können die, galvanisch aufgefüllt, Metallnetze ergeben.

**Patentansprüche**

1. Verfahren zur lithographischen Herstellung von galvanischabformbaren Mikrostrukturen mit dreieckigem oder trapezförmigem Querschnitt aus Resistmaterial, bei dem

a) eine Schicht des Resistmaterials auf einer elektrisch leitenden Unterlage aufgebracht wird,

b) die Resistschicht mittels eines fokussierten und bewegten Strahls oder mittels einer Strahlung, die mit einer senkrecht hierzu angeordneten Maske partiell abgeschattet wird, in bänderförmigen Teilbereichen bestrahlt wird,

c) die bestrahlten Bereiche der Resistschicht mit einem Entwickler entfernt werden, so daß Mikrostrukturen in der Resistschicht entstehen und in den Zwischenräumen zwischen den Mikrostrukturen die elektrisch leitende Unterlage freigelegt wird, wobei sich die entstehenden Resiststrukturen galvanisch abformen lassen, indem

d) die elektrisch leitende Unterlage als Kathode geschaltet wird und die Zwischenräume galvanisch mit Metall aufgefüllt werden und anschließend

e) das Resistmaterial und die elektrisch leitende Unterlage entfernt werden,

dadurch gekennzeichnet, daß

f) die Resistschicht für eine erste Bestrahlung gegen eine senkrecht zur einfallenden Strahlung definierte Ebene um einen Winkel + α gedreht wird, anschließend

g) die Resistschicht für eine zweite Bestrahlung gegen die senkrecht zur einfallenden Strahlung definierte Ebene um den Winkel - α gedreht wird, wobei sich die während der ersten und während der zweiten Bestrahlung bestrahlten bänderförmigen Bereiche an der Grenzfläche zwischen Resistschicht und Unterlage überlappen, wonach

h) die Resistschicht in an sich bekannter Weise entwickelt wird.

2. Verfahren nach Anspruch 1, dadurch gekennzeichnet, daß im Anschluß an die Verfahrensschritte f) bis g) die Resistschicht innerhalb der senkrecht zur einfallenden Strahlung definierten Ebene um einen Winkel β gedreht wird, wonach die Verfahrensschritte f) bis h) durchgeführt werden.

3. Verfahren nach Anspruch 1 oder 2, dadurch gekennzeichnet, daß zur Herstellung von Mikrostrukturen mit dreieckigem Querschnitt der Winkel α gleich arcsin (a/2d) gewählt wird, wo a den Abstand der Öffnungen in der Maske und d die Schichtdicke des Resistmaterials bedeutet, wobei sich die während der ersten und während der zweiten Bestrahlung bestrahlten Bereiche außer an der Grenzfläche zwischen Resistschicht und Unterlage auch an der Oberfläche der Resistschicht überlappen.

4. Verfahren nach Anspruch 1 oder 2, dadurch gekennzeichnet, daß zur Herstellung von Mikrostrukturen mit trapezförmigem Querschnitt der Winkel α kleiner arcsin (a/2d) gewählt wird, wo a den Abstand der Öffnungen in der Maske und d die Schichtdicke des Resistmaterials bedeutet.

5. Verfahren nach einem der Ansprüche 1 bis 4, dadurch gekennzeichnet, daß Masken mit schlitzförmigen Öffnungen verwendet werden.

## Revendications

1. Procédé de fabrication lithographique de microstructures formables par voie galvanique avec une section transversale triangulaire ou trapézoïdale en matériau résiste, dans lequel :

a) une couche du matériau résiste est appliquée sur une base électriquement conductrice,

b) la couche de résiste est irradiée en zones partielles en forme de rubans, au moyen d'un rayon mu et focalisé ou au moyen d'un rayonnement, qui est partiellement obscurci par un cache dispose perpendiculairement à la couche,

c) les zones de la couche de résiste irradiées sont enlevées avec un révélateur, de sorte que prennent naissance des microstructures dans la couche de résiste et que dans les espaces intermédiaires entre les microstructures la base conductrice électrique est mise à nu, les structures de résiste naissantes pouvant être formées par voie galvanique, tandis que,

d) la base électriquement conductrice est branchée comme cathode et les intervalles intermédiaires sont remplis avec du métal par voie galvanique et ensuite,

e) le matériau résiste et la base électriquement conductrice sont éliminés,

caractérisé en ce que,

f) la couche de résiste pour une première irradiation est tournée d'un angle (+ α) contre un plan défini perpendiculairement au rayonnement incident, ensuite,

g) la couche de résiste est tournée d'un angle (- α) contre le plan défini perpendiculairement au rayonnement incident, tandis que les zones en forme de ruban irradiées pendant la première et pendant la seconde irradiation se recouvrent sur la surface limite entre la couche de résiste et la base, après quoi,

h) la couche de résiste est développée de la manière connue en soi.

2. Procédé selon la revendication 1, caractérisé en ce que comme suite aux phases de procédé f) à g) la couche de résiste est tournée d'un angle β dans le plan défini perpendiculairement au rayonnement incident.

3. Procédé selon les revendications 1 ou 2, caractérisé en ce que pour fabriquer des microstructures ayant une section transversale triangulaire, l'angle α est choisi égal à arcsin (a/2d), où a représente l'écartement des ouvertures dans le cache et d l'épaisseur de la couche du matériau résiste, les zones irradiées pendant la première et pendant la deuxième irradiation se recouvrant outre que sur la zone limite entre la couche de résiste et la base, également sur la surface supérieure de la couche de résiste.

4. Procédé selon les revendications 1 ou 2, caractérisé en ce que pour la fabrication de microstructures ayant une section transversale de forme trapézoïdale, l'angle α est choisi inférieur a arcsin (a/2d), où a représente l'écartement des ouvertures dans le cache et d l'épaisseur de la couche du matériau résiste.

5. Procédé selon une des revendications 1 à 4, caractérisé en ce qu'on utilise des caches avec des ouvertures en forme de fentes.

**Claims**

1. Method of lithographically producing, from resist material, galvanically deformable microstructures having a triangular or trapezoidal cross-section, wherein

   a) a layer of resist material is applied to an electrically conductive base,

   b) the resist layer is irradiated in band-like partial regions by means of a focussed and moving beam or by means of a radiation which is partially blocked by a mask disposed perpendicularly thereto,

   c) the irradiated regions of the resist layer are removed by a developer, so tnat microstructures are produced in the resist layer and the electrically conductive base is exposed in the intermediate spaces between the microstructures, whereby the resultant resist structures can be galvanically deformed, in that

   d) the electrically conductive base is connected as a cathode, and the intermediate spaces are galvanically filled with metal, and subsequently

   e) the resist material and the electrically conductive base are removed, characterised in that

   f) the resist layer is rotated for a first irradiation through an angle +α relative to a plane perpendicular to the incident radiation, then

   g) the resist layer is rotated for a second irradiation through the angle -α relative to the plane perpendicular to the incident radiation, whereby the band-like regions, which are irradiated during the first and during the second irradiation, overlap one another at the boundary face between resist layer and base, after which

   h) the resist layer is developed in a manner known per se.

2. Method according to claim 1, characterised in that, subsequent to the method steps f) to g), the resist layer is rotated through an angle β internally of the plane perpendicular to the incident radiation, after which the method steps f) to h) are carried out.

3. Method according to claim 1 or 2, characterised in that, for the production of microstructures having a triangular cross-section, the angle α is selected to be equal to arcsin (a/2d) where $\underline{a}$ is the spacing between the openings in the mask and $\underline{d}$ is the layer thickness of the resist material, whereby the regions, which are irradiated during the first and during the second irradiation, also overlap one another on the surface of the resist layer as well as at the boundary face between resist layer and base.

4. Method according to claim 1 or 2, characterised in that, for the production of microstructures having a trapezoidal cross-section, the angle α is selected be smaller than arcsin (a/2d), where $\underline{a}$ is the spacing between the openings in the mask and $\underline{d}$ is the layer thickness of the resist material.

5. Method according to one of claims 1 to 4, characterized in that masks with slot-like openings are used.

FIG.1

FIG.2a

FIG.2b

FIG.3